# EUROPEAN PATENT APPLICATION

(11) **EP 2 530 705 A2**
(43) Date of publication of application: **05.12.2012**
(21) Application number: 11737256.5
(22) Date of filing: 21.01.2011
(51) Int. Cl.: H01L 21/205

(54) **VACUUM DEPOSITION APPARATUS**

(30) Priority: 27.01.2010 KR 20100007470
(71) Applicant: SNU Precision Co., Ltd., Asan-si Chungcheongnam-do 336-871 (KR)
(72) Inventor: BAK, Byeong Min, Namyangju-si Gyeonggi-do 472-831 (KR); GONG, Doo Won, Seoul 158-848 (KR); KWON, Jin Haon, Cheonan-si Chungcheongnam-do 331-963 (KR); JUNG, Yong Beom, Osan-si Gyeonggi-do 447-743 (KR); CHO, Whang Sin, Seoul 122-819 (KR); JUNG, Sung Jae, Seongnam-si Gyeonggi-do 463-928 (KR)
(74) Representative: Chaillot, Geneviève
(86) International application number: PCT/KR2011/000423
(87) International publication number: WO 2011/093617

(57) **Abstract**

Disclosed is a vacuum deposition apparatus, which comprises: a chamber mounted with a source for jetting an application material in the gaseous state for deposition onto a substrate; heaters formed to the inner wall of the chamber and internal parts; a pump for aspirating air out of the chamber; and a plurality of cold traps interposed between the chamber and the pump for cooling the air aspirated by the pump to remove the application material from the air. According to the vacuum deposition apparatus, it is possible to prevent direct damage to the internal parts or the inner wall of the chamber by application materials accumulated thereon. Additionally, the plurality of cold traps prevent pollution and stoppage in continuous production which allows substitution to be carried out without stoppage. Therefore, productivity may be improved compared to other equipment with similar specifications.

## Description

### [Technical Field]

The present invention relates to a vacuum deposition apparatus, and more particularly to a vacuum deposition apparatus, in which pollutants are effectively removed from an inside of a chamber, and thus production continues without stopping a process.

### [Background Art]

In manufacturing a display or a solar cell, a vacuum deposition method has been generally used in industries as a physical deposition method for forming a thin film on a substrate. The vacuum deposition is a method in which materials to be coated are physically or chemically evaporated or sublimed in a vacuum and solidified as an atomic or molecular unit on a surface of a substrate, thereby forming a thin film.

Such a vacuum deposition method is applicable to almost all articles, and employs a vacuum deposition apparatus since it needs a vacuum condition for the vacuum deposition. The vacuum deposition apparatus lets air out of a chamber, evaporates a material in a vacuum, jets the evaporated material and forms the thin film on the substrate.

However, application materials not deposited on the substrate during the process may be attached to an inner wall of the chamber or to other parts inside the chamber, thereby deteriorating the durability of the apparatus. Therefore, there is a need of removing the application materials that pollute the inside and parts of the chamber.

The conventional apparatus is provided with an attachment-preventing plate installed on the inner wall or parts of the chamber so as to accumulate the application material thereon. When the application material is accumulated to some degree, it may cause a product to be defective. Therefore, it is inefficient since the production has to be suspended to replace the attachment-preventing plate having the application materials accumulated thereon with a new one, and then resumed.

Thus, the conventional apparatus inevitably involves decrease of an output due to the stoppage of the production, and the parts or devices thereof may be decreased in performance and damaged by the application material because the minute particles of the application material can pollute the parts or devices via a gap even though the attachment-preventing plate is installed.

### [Disclosure]

### [Technical Problem]

Therefore, the present invention is directed to prevent an application material from being accumulated inside a chamber and polluting a vacuum deposition apparatus.

Another aspect of the present invention is to operate a vacuum deposition apparatus without stopping a process.

### [Technical Solution]

One aspect of the present invention provides a vacuum deposition apparatus including: a chamber to which a plurality of sources is mounted and in which some among the plurality of sources are selected to jet an application material in a gaseous state for deposition onto a substrate; a heater which is mounted to an inner wall and internal parts of the chamber; a pump which lets air out of the chamber; and a plurality of cold traps which is interposed between the chamber and the pump and cools the air inhaled by the pump to remove the application material from air, wherein some among the plurality of cold traps are selected to remove the application material.

The vacuum deposition apparatus may further include a discharging pipe connecting the chamber and the pump, wherein the cold trap is provided at an end or in a middle of the discharging pipe.

The cold trap may include a plurality of wings obliquely formed with regard to a direction where air passes.

The vacuum deposition apparatus may further include a vacuum valve at opposite sides of the cold trap.

The plurality of wings may be supported by a cooling pipe in which cooling water flows, and maintains temperature by the cooling water.

The chamber may include a gate through which the substrate comes in and out, the gate may be closed by a gate valve, and the gate valve may further include a gate cold trap at a lateral side thereof.

The vacuum deposition apparatus may further include an attachment-preventing plate which covers the inner wall, internal parts and heater of the chamber.

The vacuum deposition apparatus may further include at least one of a linear motion (LM) guide provided under the chamber and a bellows provided at opposite ends of the chamber.

### [Advantageous Effects]

The present invention has an effect of preventing an application material from being accumulated on and directly damaging internal parts or an inner wall of a chamber.

Also, the present invention has an effect of improving productivity as compared with other apparatuses having the same specification because a plurality of sources and cold traps are used without stoppage of a process when they are replaced.

### [Description of Drawing]

Fig. 1 is a perspective view showing a vacuum deposition apparatus according to an exemplary embodiment of the present invention.
Fig. 2 is a lateral cross-section view showing a vacuum deposition apparatus according to an exemplary embodiment of the present invention.
Fig. 3 is a perspective view showing a cold trap according to an exemplary embodiment of the present invention.
Fig. 4 is a lateral view showing the cold trap according to an exemplary embodiment of the present invention.
Fig. 5 is a lateral sectional view showing a vacuum deposition apparatus where a plurality of chambers are connected according to an exemplary embodiment of the present invention.

### [Best Mode]

Certain embodiments of the present invention will be shown in drawings and described in detail even though the present invention may be variously modified and have many embodiments. However, it should be understood that the present invention is not limited to the following embodiments of and includes all the modifications, equivalents and alternatives without departing from the spirit and scope of the invention. If detailed descriptions about related publicly known technologies may be off the main point of the present invention, it will be omitted.

The terms used in this specification are just used for explaining the certain embodiments, and not intended to limit the invention. The singular form includes the plural form as long as it is not contextually distinguishably and clearly expressed. Further, it will be appreciated that the terms "include", "have" or the like are intended to designate presence of the features, numbers, steps, operations, elements, parts of combinations thereof described in the specification, but not to previously exclude possibility of the presence or addition of one or more other features, numbers, steps, operations, elements, parts of combinations thereof.

Hereinafter, exemplary embodiments of a vacuum deposition apparatus according to the present invention will be described in detail with reference to accompanying drawings, in which like numbers refer to like elements and repetitive descriptions thereof will be avoided as necessary.

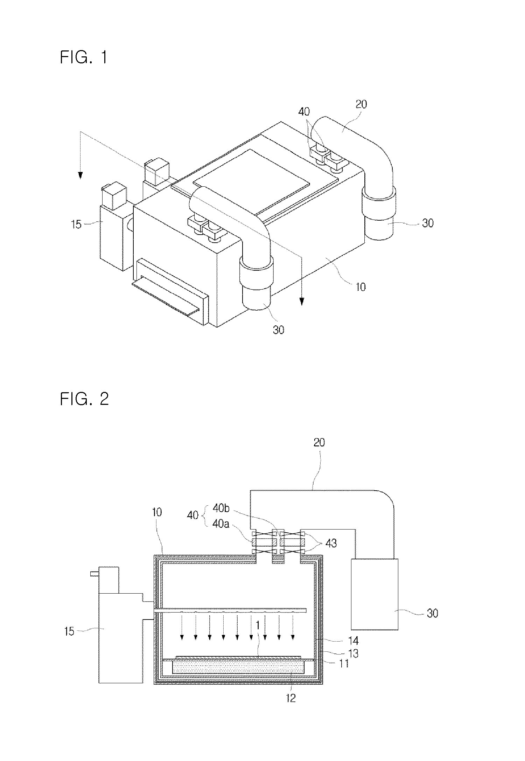

Fig. 1 is a perspective view showing a vacuum deposition apparatus according to an exemplary embodiment of the present invention, and Fig. 2 is a lateral cross-section view showing a vacuum deposition apparatus according to an exemplary embodiment of the present invention. Referring to Figs. 1 and 2, a substrate 1, a chamber 10, a carrier 11, a roller 12, a heater 13, an attachment-preventing plate 14, a source 15, a discharging pipe 20, a pump 30, a cold trap 40 and a vacuum valve 43 are illustrated.

The vacuum deposition apparatus is classified into an in-line type where a plurality of chambers are connected and the substrate undergoes processes while successively moving between the chambers, and a cluster type where chambers are provided independently of one another and the substrate is inserted in one chamber for one process and then inserted in another chamber for the next process. The exemplary embodiments of the present invention are related to the vacuum deposition apparatus practically usable to both types.

The chamber 10 is a place where a vacuum deposition process is performed, the interior of which can be maintained in a vacuum by pumping out inner air thereof through the pump 30. Also, the chamber 10 connects with the pump 30 through the discharging pipe 20. The chamber 10 may internally include a roller 12 and a carrier 11 for moving the substrate 1. Since the substrate 1 is put on the carrier 11, the carrier 11 moves when the roller 12 rotates and thus the substrate 1 moves.

The source 15 is a device for jetting an application material to the interior of the chamber 10 in a gaseous state for deposition onto the substrate. One or more sources are provided per chamber 10. In the case where the plurality of sources 15 are provided, if the sources 15 need to be replaced, some of them are selectively used to jet the application material and some to be replaced are stopped and then replaced. Thus, it is possible to replace the sources 15 without stopping the vacuum deposition process.

The application materials used for the source 15 are materials that can have the gaseous state at a certain temperature, which for example include Se, Csl, TICl₃ and low molecular organic materials (Alq₃, NPB, etc), and so on.

If some of the jetted application materials are not deposited on the substrate 1 and remained in the chamber 10, the remaining application materials are attached to the inner wall of the chamber and the internal parts of the chamber 10 and causes pollution of the vacuum deposition apparatus. According to an exemplary embodiment, the heaters 13 are installed in the inner wall and parts of the chamber 10 in order to prevent such pollution, and heat the application material at a temperature higher than the evaporation point, thereby preventing the application material from being attached to the inner wall or parts of the chamber 10.

According to another exemplary embodiment of the present invention, an attachment-preventing plate 14 is added to cover the inner wall and parts of the chamber 10 and the heaters 13, so that the application material cannot directly contact the inner wall, parts and heaters 13 of the chamber 10. If the application material is deposited more than a predetermined level, the attachment-preventing plate 14 is replaced to thereby keep the state of the vacuum deposition apparatus.

As a part at which the heater 13 can be installed, there are a roller, a roller edge, a window provided in a chamber, etc. Besides, the heaters 13 may be installed at all parts which are exposed to the inside of the chamber 10 and to which the application materials may be attached. To maintain the thermal efficiency of the heater, an insulator may be attached to the outer wall of the chamber.

The pump 30 inhales air in the chamber 10 and lowers internal pressure of the chamber 10, thereby making the chamber vacuous. At this time, if the application material remaining in the chamber 10 is inhaled together with air by the pump 30, the pump 30 may be polluted. According to an exemplary embodiment, in order to prevent such pollution, the cold trap 40 is provided at an end or in the middle of the discharging pipe 20 connecting the chamber 10 and the pump 30.

The cold trap 40 cools air inhaled by the pump 30 and filters the application material out of air. To effectively filter the application material out of air, the cold trap 40 has to have a large surface area to contact air and keep its temperature low.

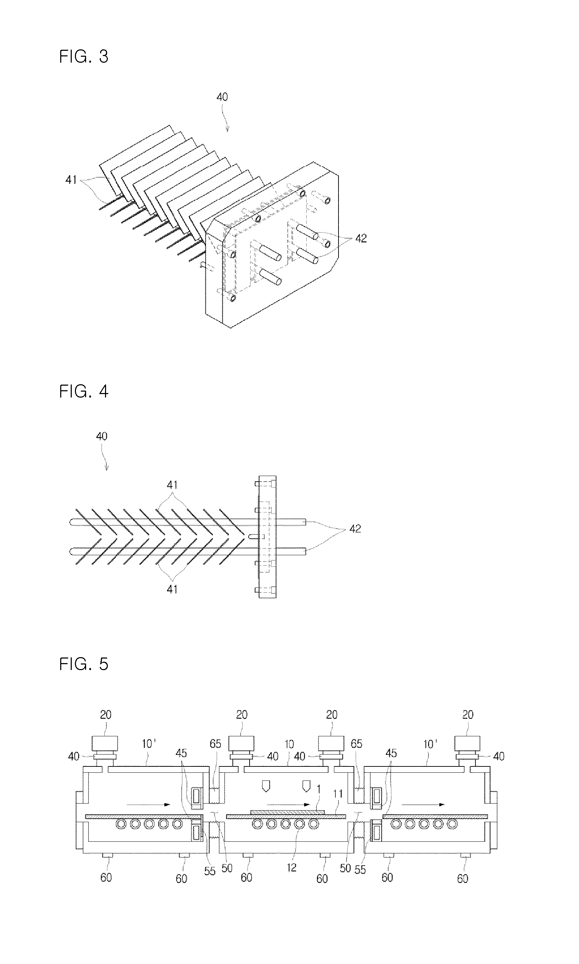

Detailed exemplary embodiments of the cold trap 40 are illustrated in Figs. 3 and 4. Fig. 3 is a perspective view showing a cold trap according to an exemplary embodiment of the present invention, and Fig. 4 is a lateral view showing the cold trap according to an exemplary embodiment of the present invention, which shows a wing 41 and a cooling pipe 42.

According to an exemplary embodiment, to enlarge the surface area of the cold trap 40, the wing 41 may be obliquely formed with regard to a direction where air passes. Since the air goes along the discharging pipe, the wing 41 is formed obliquely to the direction of the discharging pipe. As shown in Fig. 4, a plurality of wings 41 is formed to guide air to flow zigzag and increase the area where the cold trap 40 and air are in contact with each other. If air contacts the cold wing 41, the application material in air is cooled and attached to the wing 41, thereby preventing the pump 30 from pollution. The cold trap 40 may be periodically replaced to remove the application material.

The wing 41 is supported by the cooling pipe 42, and exchanges heat with cooling water or LN₂ having a low temperature and flowing in the cooling pipe 42 so that the temperature of the wing 41 is maintained to be lower than the evaporation point of the application material. In this case, if a material for the wing has high heat conductivity, the cold trap 40 can more efficiently prevent the pollution due to the application material.

The shapes of the wing 41 and the cooling pipe 42 are not limited to those shown in Figs. 3 and 4, but may be varied as long as the wing 41 increases the surface area to contact air and the cooling pipe 42 maintains the low temperature.

The cold trap 40 has a relatively short replacement cycle because the application material is intensively accumulated thereon. Therefore, if the vacuum deposition apparatus is wholly stopped for the replacement, it takes much time to make it vacuous again. However, this problem can be solved if the plurality of cold traps 40 is provided per chamber 10. Specifically, referring to Fig. 2, when one cold trap 40a is replaced, another cold trap 40b continues to filter the application material out. Therefore, there is no need of stopping of the vacuum deposition apparatus. At this time, vacuum valves 43 are provided at opposite ends of the cold trap 40 and intercepts air flowing toward the cold trap 40 before the cold trap 40 is replaced.

Fig. 5 is a lateral sectional view showing a vacuum deposition apparatus where a plurality of chambers are connected according to an exemplary embodiment of the present invention. In Fig. 5, a substrate 1, a chamber 10, 10', a carrier 11, a roller 12, a discharging pipe 20, a cold trap 40, a gate cold trap 45, a gate 50, a gate valve 55, an LM guide 60, and a bellows 65 are illustrated.

Using this apparatus, the substrate 1 can undergo vacuum deposition processes successively while moving between the connected chambers 10 and 10'.s

Specifically, the chamber 10 may further include the gate 50 opened and closed by the gate valve 55 for allowing the entrance and exit of the substrate 1. When the gate valve 55 is opened, the application materials remaining in the chamber 10 where the vacuum deposition process is performed may move to and pollute another neighboring chamber 10'. According to this exemplary embodiment, the gate 50 of the chamber 10 may be provided with the gate cold trap 45 for removing the application materials.

If the chamber 10 and the chamber 10' are fixed, the chamber 10 may be deformed by thermal expansion when the chamber 10 is heated by the heater 13. Thus, the bellows 65 may be provided between the chambers so as to adjust a space between the chamber 10 and the neighboring chamber 10'. The bellows 65 is made of a flexible material, so that the bellows 65 can be deformed when the chamber 10 is deformed by the thermal expansion, thereby adjusting the space between the chamber 10 and the neighboring chamber 10'.

Also, the LM guide 60 is provided under the chamber 10 and the neighboring chamber 10' so that the chamber 10 and the neighboring chamber 10' can move left and right corresponding to the thermal expansion. Thus, it is possible to minimize accumulation of stress onto the chambers 10 and 10'. The LM guide 60 is a device for allowing rectilinear motion along rails formed in a certain direction, which is provided under the chamber 10, thereby allowing the chamber to move forward, backward, leftward and rightward along the rails of the LM guide 60.

Although a few exemplary embodiments have been shown and described, it will be appreciated by a person having an ordinary skill in the art that changes may be made in these exemplary embodiments without departing from the principles and spirit of the invention, the scope of which is defined in the appended claims and their equivalents.

In addition to the foregoing exemplary embodiments, a lot of embodiments are conceivable from the claims.

## Claims

1. A vacuum deposition apparatus comprising:
a chamber to which a plurality of sources is mounted and in which some among the plurality of sources are selected to jet an application material in a gaseous state for deposition onto a substrate;
a heater which is mounted to an inner wall and internal parts of the chamber;
a pump which lets air out of the chamber; and
a plurality of cold traps which is interposed between the chamber and the pump and cools the air inhaled by the pump to remove the application material from air, wherein some among the plurality of cold traps are selected to remove the application material.

2. The vacuum deposition apparatus according to claim 1, further comprising a discharging pipe connecting the chamber and the pump,
wherein the cold trap is provided at an end or in a middle of the discharging pipe.

3. The vacuum deposition apparatus according to claim 1, wherein the cold trap comprises a plurality of wings obliquely formed with regard to a direction where air passes.

4. The vacuum deposition apparatus according to claim 1, further comprising a vacuum valve provided at opposite sides of the cold trap.

5. The vacuum deposition apparatus according to claim 3, wherein the plurality of wings is supported by a cooling pipe in which cooling water flows, and maintains temperature by the cooling water.

6. The vacuum deposition apparatus according to claim 1, wherein the chamber comprises a gate through which the substrate comes in and out,
the gate is closed by a gate valve, and
the gate valve further comprises a gate cold trap at a lateral side thereof.

7. The vacuum deposition apparatus according to claim 1, further comprising an attachment-preventing plate which covers the inner wall, internal parts and heater of the chamber.

8. The vacuum deposition apparatus according to claim 1, further comprising at least one of a linear motion (LM) guide provided under the chamber and a bellows provided at opposite ends of the chamber.
